Europäisches Patentamt

European Patent Office

Office européen des brevets

(11) Numéro de publication: **0 248 473 B1**

(12) **FASCICULE DE BREVET EUROPEEN**

(45) Date de publication de fascicule du brevet:
08.05.91

(21) Numéro de dépôt: 87200978.2

(22) Date de dépôt: **27.05.87**

(51) Int. Cl.⁵: **H03K 19/0175**, H03K 19/082

(54) **Circuit convertisseur de niveaux logiques à trois états.**

(30) Priorité: 06.06.86 FR 8608184

(43) Date de publication de la demande:
09.12.87 Bulletin 87/50

(45) Mention de la délivrance du brevet:
08.05.91 Bulletin 91/19

(84) Etats contractants désignés:
**DE FR GB IT NL**

(56) Documents cités:
**EP-A- 0 097 857**
**WO-A-86/02792**

IBM TECHNICAL DISCLOSURE BULLETIN, vol.
26, no. 7A, décembre 1983, pages 3255-3256,
New York, US; L.B. FREEMAN: "Three-state
off-chip driver"

IBM TECHNICAL DISCLOSURE BULLETIN, vol.
21, no. 7, décembre 1978, pages 2905-2906,
New York, US; R.D. BURKE: "Bipolar three-
state driver"

(73) Titulaire: **PHILIPS COMPOSANTS**
**117, quai du Président Roosevelt**
**F-92130 Issy les Moulineaux(FR)FR**

Titulaire: **N.V. Philips' Gloeilampenfabrieken**
**Groenewoudseweg 1**
**NL-5621 BA Eindhoven(NL)DE GB IT NL**

(72) Inventeur: **Gloaguen, Gilbert Société Civile**
**S.P.I.D.**
**209, rue de l'Université**
**F-75007 Paris(FR)**

(74) Mandataire: **Jacquard, Philippe et al**
**Société Civile S.P.I.D. 156, Boulevard Haus-**
**smann**
**F-75008 Paris(FR)**

## Description

La présente invention a pour objet un circuit convertisseur de niveaux logiques entre une logique du type mettant en oeuvre des paires de transistors à émetteurs couplés (ECL, CML) et une logique du type transistor-transistor (TTL), et comportant un étage différentiel d'entrée présentant au moins un premier et un deuxième transistors dont les émetteurs sont couplés et une source de courant principale disposée entre lesdits émetteurs couplés et une source de tension d'alimentation négative, dont les collecteurs sont reliés à une source de tension d'alimentation positive chacun à travers respectivement une première et une deuxième resistance, la base du premier transistor étant portée à une tension de référence et celle du deuxième transistor recevant un signal d'entrée dont le niveau est à translater, une première et deuxième diode ayant leur anode reliée à la masse et leur cathode reliée au collecteur respectivement du premier et du deuxième transistor, et comportant également un étage de sortie présentant un cinquième et un sixième transistor dont les trajets collecteur-émetteur sont en série, le cinquième transistor ayant son émetteur connecté à la masse, sa base connectée au collecteur du premier transistor et son collecteur connecté à l'émetteur du sixième transistor en un point constituant la sortie du circuit convertisseur et le sixième transistor ayant sa base reliée au collecteur du deuxième transistor et son collecteur connecté à la source de tension d'alimentation positive.

Un tel circuit convertisseur a déjà été mis en oeuvre, dans des cellules commercialisées sous la dénomination ACE par la Demanderesse sous la référence OTTL 4, mais il présente l'inconvénient de ne présenter que deux états à faible impédance de sortie.

Or, il est de plus en plus demandé que de tels circuits puissent être associés avec leurs sorties connectées en parallèle. Pour cette utilisation, il est nécessaire de pouvoir mettre les circuits dans un troisième état où leur sortie présente une impédance très élevée, indépendamment des signaux qu'ils reçoivent à leur entrée. Les circuits associés en parallèle sont alors utilisés en mettant n - 1 circuits dans le troisième état, un circuit sélectionné ayant sa sortie dans le premier ou le deuxième état, en fonction du signal qu'il reçoit à son entrée logique.

Le fait de réaliser des circuits logiques à trois états est en soi connu par exemple de l'antériorité IBM Technical Disclosures Bulletin vol.26 n° 7A déc. 1983, laquelle concerne spécifiquement un driver de type push-pull à commutation de courant. Un tel circuit ne convient pas dans le cas d'un circuit convertisseur de niveaux logiques.

L'invention a pour objet un circuit convertisseur du type précité et qui comporte un tel troisième état, tout en évitant d'ajouter une deuxième source de courant principale supplémentaire.

Dans ce but, le circuit convertisseur selon l'invention est caractérisé en ce qu'il comporte un septième et un huitième transistors dont les émetteurs sont couplés et connectés au collecteur d'un neuvième transistor dont la base est connectée à celle du deuxième transistor et dont l'émetteur est connecté aux émetteurs des premier et deuxième transistors, la base du septième transistor recevant ladite tension de référence, et le collecteur du septième transistor étant connecté à la masse, la base du huitième transistor étant connectée à la base d'un dixième transistor, laquelle constitue une entrée de sélection dudit troisième état, et dont le collecteur et l'émetteur sont connectés respectivement à la masse et à la base du deuxième transistor, et le collecteur du huitième transistor étant connecté à celui du deuxième transistor, et en ce qu'il comporte une troisième diode dont l'anode est connectée à la base du cinquième transistor et dont la cathode est connectée au collecteur du deuxième transistor.

Selon une variante permettant de décaler le niveau de l'entrée, l'étage différentiel d'entrée comporte un troisième transistor dont le collecteur est à la masse, dont la base reçoit ladite tension de référence et dont l'émetteur est connecté à la base du premier transistor ainsi qu'un quatrième transistor dont la base reçoit directement ledit signal d'entrée, dont l'émetteur est connecté à la base du deuxième transistor et dont le collecteur est à la masse, une première et une deuxième source de courant auxiliaire étant connectées à l'émetteur respectivement du troisième et du quatrième transistor.

Selon un mode de réalisation préféré, ladite troisième diode est la diode base-émetteur d'un onzième transistor dont la base est connectée à la base du cinquième transistor et dont le collecteur est connecté à la base du sixième transistor de telle sorte que la base du sixième transistor et la deuxième résistance sont reliés au collecteur du deuxième transistor à travers le trajet collecteur-émetteur du onzième transistor.

On obtient ainsi une isolation de certains éléments du circuit par rapport à la tension d'alimentation positive, ce qui évite à la deuxième diode, au deuxième et au huitième transistor de supporter des tensions en inverse à la limite des tensions d'avalanche des jonctions.

Il est également souhaitable d'éviter la saturation du cinquième transistor et le cas échéant du onzième transistor.

Selon une première variante, ces transistors sont des transistors Schottky.

2

Selon une deuxième variante, permettant d'éviter de recourir à une technologie Schottky, une troisième résistance est disposée en série entre le collecteur du premier transistor et la première résistance, et on met en oeuvre une quatrième et cinquième diodes dont les anodes sont connectées entre elles au point commun à la première et à la troisième résistances, la cathode de la quatrième diode étant connectée à la sortie du circuit convertisseur et celle de la cinquième diode au collecteur du onzième transistor ainsi qu'une troisième source de courant auxiliaire entre le collecteur du premier transistor et la source de tension d'alimentation négative, le produit de la valeur de la troisième résistance et de l'intensité de la troisième source de courant auxiliaire étant tel que la saturation des cinquième et onzième transistors soit évitée.

L'invention sera mieux comprise à la lecture de la description qui va suivre donnée à titre d'exemple non limitatif en liaison avec les dessins qui représentent :
- La figure 1, un circuit convertisseur de l'art antérieur
- La figure 2, un circuit convertisseur selon un premier mode de réalisation de l'invention
- Les figures 3, 4 et 5, des schémas équivalents correspondant au fonctionnement du circuit de la figure 2 dans les trois états qu'il peut présenter à sa sortie.
- La figure 6, un mode préféré de réalisation de l'invention.
- La figure 7, une variante du mode de réalisation précédent.

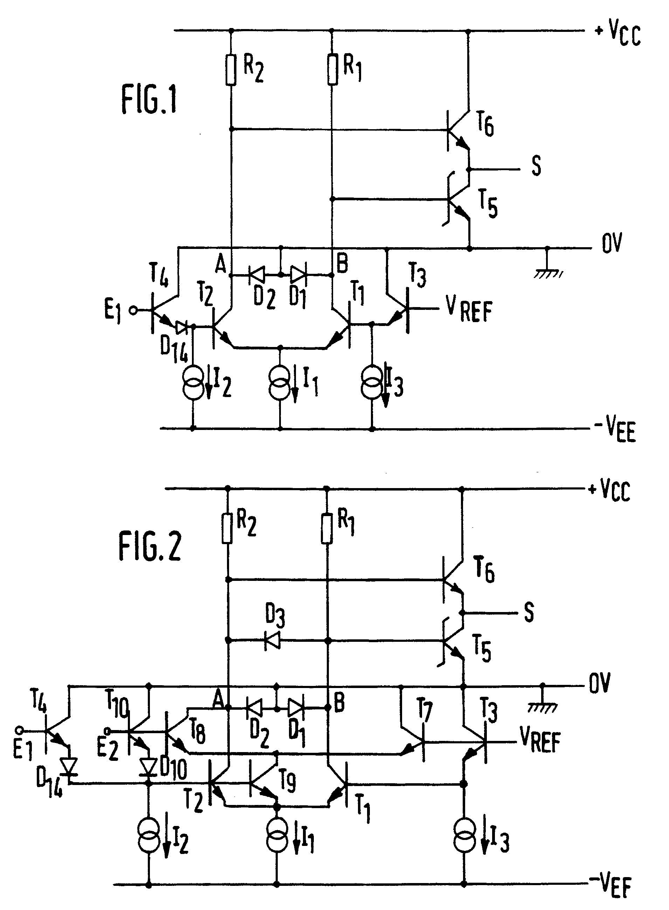

Selon la figure 1, un circuit convertisseur à deux niveaux de l'art antérieur comporte un étage différentiel comportant au moins deux transistors $T_1$ et $T_2$ couplés par les émetteurs, ceux-ci étant connectés à une source de courant principale $I_1$ (débitant un courant par exemple de 5 mA) reliée à une tension d'alimentation négative - VEE. Les collecteurs des transistors $T_1$ et $T_2$ sont reliés à une tension d'alimentation positive + Vcc par l'intermédiaire de résistances respectivement $R_1$ et $R_2$. Deux diodes $D_1$ et $D_2$ ont leur cathode connectée au collecteur respectivement du transistor $T_1$ (point B) et du transistor $T_2$ (point A), et leur anode à la masse OV. La base du transistor $T_1$ est destinée à être portée à une tension de référence et celle du transistor $T_2$ à recevoir des signaux d'entrée.

Dans le cas où un décalage du niveau d'entrée s'avère nécessaire, la base du transistor $T_1$ est attaquée par un transistor $T_3$ monté en émetteur suiveur, dont la base reçoit directement une tension de référence VREF et dont le collecteur est à la masse. De même, la base du transistor $T_2$ est attaquée par un transistor $T_4$ monté en émetteur suiveur, dont la base reçoit directement un signal logique d'entrée $E_1$, et dont le collecteur est à la masse. Des sources de courant auxiliaires $I_2$ et $I_3$ débitant chacune par exemple un courant de 0,5 mA sont connectés entre l'émetteur respectivement des transistors $T_4$ et $T_3$ et la source de tension d'alimentation négative -VEE. Les transistors $T_3$ et $T_4$ permettent d'abaisser d'une tension émetteur-base VBE le niveau d'entrée $E_1$ ainsi que VREF. Une diode $D_{14}$ peut être le cas échéant également ajoutée en série et en direct dans l'émetteur de $T_4$ de manière à assurer la compatibilité des niveaux.

Deux transistors $T_5$ et $T_6$ ont leurs trajets, collecteur-émetteur en série. L'émetteur du transistor $T_5$ est connecté à la masse OV, et son collecteur à l'émetteur du transistor $T_6$ dont le collecteur est connecté à la tension d'alimentation positive + Vcc. La base du transistor $T_5$ est connectée au collecteur du transistor $T_1$ (point B), et celle du transistor $T_6$ au collecteur du transistor $T_2$ (point A).

L'entrée $E_1$ reçoit des signaux en logique du type mettant en oeuvre des paires de transistors à émetteurs couplés (ECL, CML) et le point commun à l'émetteur du transistor $T_6$ et au collecteur du transistor $T_5$ constitue la sortie S du convertisseur, en logique transistor-transistor (TTL).

Lorsque $E_1$ est au niveau haut, les transistors $T_4$ et $T_2$ sont conducteurs et le courant $I_1$ traverse la résistance $R_2$ et la diode $D_2$. La diode $D_2$ qui conduit fixe le potentiel du point A à -VBE, VBE désignant une tension base-émetteur d'un transistor (environ 0,7 V). Le transistor $T_6$ est bloqué et le transistor $T_5$ est conducteur. La sortie S est alors au niveau bas, avec une impédance de sortie faible. Lorsque $E_1$ est au niveau bas, les transistors $T_3$ et $T_1$ sont conducteurs et le courant $I_1$ traverse le transistor $T_1$ et la diode D1. La diode $D_1$ qui conduit fixe le potentiel de point B à -VBE. Le transistor $T_5$ est bloqué et le transistor $T_6$ est conducteur. La sortie S est alors au niveau haut Vcc - VBE ($T_6$), avec une impédance de sortie faible, $V_{BE}$ ($T_6$) désignant la tension base-émetteur du transistor $T_6$.

Le circuit de la figure 2 permet au circuit de présenter un troisième état à impédance de sortie très élevée, dans lequel les transistors $T_5$ et $T_6$ sont simultanément bloqués quelque soit le signal appliqué à l'entrée $E_1$. Pour ce faire, le circuit convertisseur présente des composants additionnels, à savoir les transistors $T_7$, $T_8$, $T_9$ et $T_{10}$, et la diode $D_3$. La diode $D_3$ a son anode connectée à la base du transistor $T_5$ et sa cathode à la base du transistor $T_6$. Les transistors $T_7$ et $T_8$ sont couplés par les émetteurs. Le transistor $T_7$ a sa base connectée à celle du transistor $T_3$ et reçoit donc la tension de référence VREF, et son collecteur connecté à la masse OV. Le transistor $T_8$ a son collecteur connecté à celui du transistor $T_2$ - (point A) et sa base à celle d'un transistor $T_{10}$ dont le collecteur est connecté à la masse OV, et l'émetteur

3

à la base du transistor $T_2$.

On remarquera que si le transistor $T_4$ a une diode $D_{14}$ à série avec son émetteur, alors le transistor $T_{10}$ a une diode $D_{10}$ en série avec le sien. La base des transistors $T_8$ et $T_{10}$ reçoit un signal de commande $E_2$ permettant d'activer le troisième état du circuit convertisseur lorsque $E_2$ est au niveau haut, ainsi qu'il le sera montré dans la suite de la description.

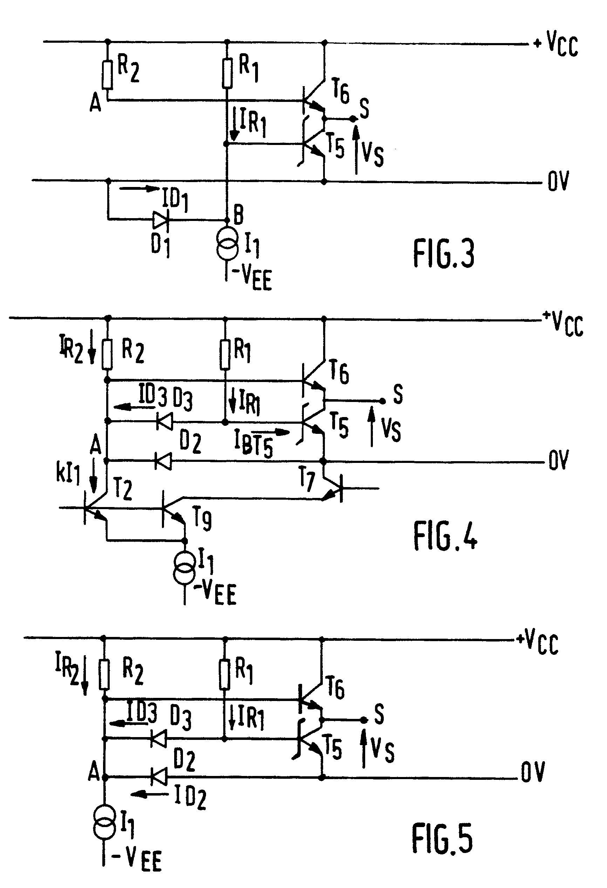

La figure 3 correspond au premier état dans lequel $E_1$ et $E_2$ sont au niveau bas. Comme les transistors $T_2$, $T_8$ et $T_9$ sont bloqués et le transistor $T_1$ est conducteur, le courant $I_1$ se partage entre la diode $D_1$ - (courant $ID_1$) et la résistance $R_1$ (courant $IR_1$). La diode $D_1$ qui conduit fixe le potentiel du point B à $-VD_1$ par rapport à la masse (OV), bloquant ainsi le transistor $T_5$. Aucun courant ne circule dans $R_2$ car les transistors $T_2$ et $T_8$ sont bloqués et les diodes $D_2$ et $D_3$ sont en inverse. Le transistor $T_6$ est de ce fait conducteur avec une faible impédance de sortie.

La condition de fonctionnement s'écrit :

$$I_1 > \frac{Vcc + VD_1}{R_1} \quad (1)$$

$VD_1$ désignant la tension aux bornes de la diode $D_1$.

La figure 4 correspond au cas deuxième état dans lequel $E_1$ est au niveau haut et $E_2$ au niveau bas. Comme les transistors $T_2$, $T_7$ et $T_9$ sont conducteurs et les transistors $T_1$ et $T_8$ sont bloqués, le courant $I_1$ se partage entre les transistors $T_2$ et $T_9$, la partie du courant $I_1$ traversant $T_9$ étant dérivé vers la masse à travers le transistor $T_7$. Seule la partie $kI_1$ (avec k inférieur à 1) passant dans le transistor $I_2$ est active. Les paramètres du circuit sont choisis de telle manière qu'aucun courant ne circule dans la diode $D_2$. Le transistor $T_5$ est conducteur et on a :

$ID_3 = IR_1 - IBT_5$

$I_{D3}$, $IR_1$ et $IBT_5$ désignant les courants traversant repectivement la diode $D_3$, la résistance $R_1$ et la base du transistor $T_5$.

Le potentiel du point A a alors pour valeur :

$VBET_5 - VD_3 \simeq OV$

$VBET_5$ désignant la tension base-émetteur du transistor $T_5$ et $VD_3$ la tension aux bornes de la diode $D_3$. La base du transistor $T_6$ se trouvant pratiquement à OV, ce dernier est bloqué. Le transistor $T_5$ qui travaille à faible tension collecteur-émetteur VCE est anti-saturé par une diode Schottky.

L'équation de fonctionnement du circuit s'écrit alors sous la forme d'une condition sur les courants.

$$\frac{V_{CC} - V_{BET_5} + V_{D3}}{R_2} < kI_1 < \frac{V_{CC} - V_{BET_5} + V_{D3}}{R_2} + \frac{V_{CC} - V_{BET_5}}{R_1}$$

ou

$$\frac{V_{CC}}{R_2} < kI_1 < \frac{V_{CC}}{R_2} + \frac{V_{CC} - V_{BET_5}}{R_1} \quad (2)$$

Le facteur k évidemment toujours inférieur à 1 est déterminé par le rapport des surfaces d'émetteur $SET_2$ et $SET_9$ des transistors $T_2$ et $T_9$ :

$$k = \frac{S_{ET_2}}{S_{ET_2} + S_{ET_9}}$$

La figure 5 correspond au troisième état dans lequel l'entrée $E_2$ est au niveau haut, indépendamment de l'état de l'entrée $E_1$.

4

Les transistors $T_2$, $T_8$ et $T_9$ sont conducteurs et les transistors $T_1$ et $T_7$ sont bloqués.

Le choix d'un courant $I_1$ suffisamment élevé, à savoir supérieur à :

$$I_{R2} + I_{D3}$$

permet de faire circuler un courant $I_{D2}$ dans la diode $D_2$ qui polarise le point A à un potentiel - $V_{D2}$ par rapport à la masse OV. On a :

$$I_1 = I_{R2} + I_{D2} + I_{D3}$$

La base du transistor $T_6$ est amenée au potentiel -$V_{D2}$et ce transistor est alors bloqué. Le potentiel de la base de transistor $T_5$ est a amené à :

$$- V_{D2} = V_{D3} \simeq OV,$$

bloquant également ce transistor. On a de ce fait :

$ID_3 = IR_1$

Les transistors $T_5$ et $T_6$ étant simultanément bloqués, le point S est équivalent à un circuit ouvert (impédance pratiquement infinie) pour VS ≧ OV, VS désignant la tension du point S.

L'équation de fonctionnement s'écrit :

$$I_1 > I_{R_2} + I_{D_3} > \frac{V_{cc} + V_{D_2}}{R_2} + \frac{V_{cc} + V_{D_2} - V_{D_3}}{R_1} \simeq \frac{V_{cc} + V_{D_2}}{R_2} + \frac{V_{cc}}{R_1} \quad (3$$

L'ensemble des équations de fonctionnement du circuit s'écrivent donc :

$$I_1 > \frac{V_{cc} + V_{D_1}}{R_1} \quad (1)$$

$$\frac{V_{cc}}{R_2} < kI_1 < \frac{V_{cc}}{R_2} + \frac{V_{cc} - V_{BET_5}}{R_1} \quad (2)$$

$$I_1 > \frac{V_{cc} + V_{D_2}}{R_2} + \frac{V_{cc}}{R_1} \quad (3)$$

Comme :

$$\frac{V_{cc} + V_{D_2}}{R_2}$$

est pratiquement toujours supérieur à :

$$\frac{V_{D_1}}{R_1},$$

la relation (1) est donc satisfaite lorsque la relation (3) l'est.

La comparaison du premier membre de la relation (2) et de la relation (3) donne :

$$k > \frac{R_1 \ V_{cc}}{R_1 \ (V_{cc} + V_{D_2}) + V_{cc} R_2}$$

que l'on exprimera plus simplement sous la forme :

$$k \, > \, \frac{R_1}{R_1 + R_2} \quad (4)$$

Le fonctionnement du circuit est assuré lorsque les conditions (3) et (4) sont simultanément remplies, et si :

$$kI_1 \, < \, \frac{V_{CC}}{R_2} + \frac{V_{CC} - V_{BET_5}}{R_1} \quad (2) \, '$$

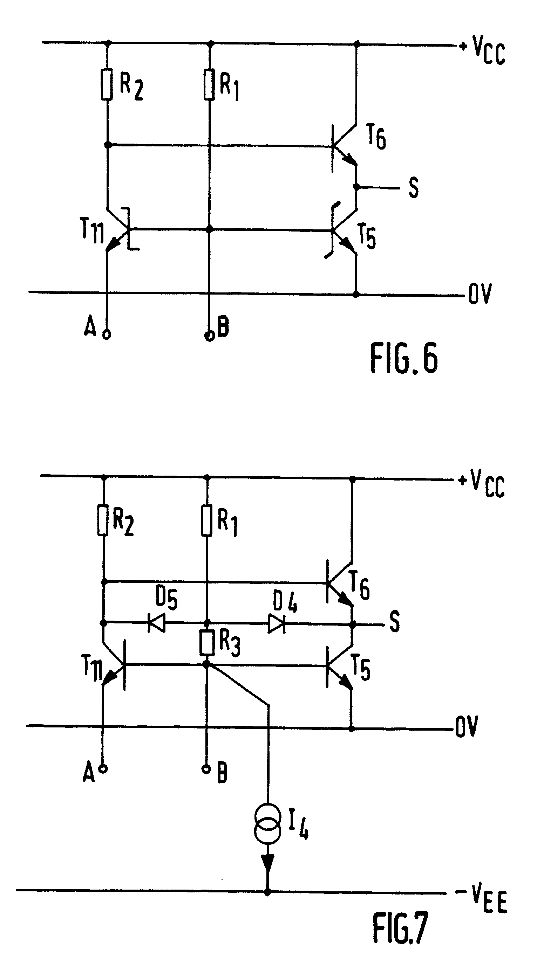

Selon la figure 6, un transistor $T_{11}$ de préférence du type Schottky dont la base est connectée à celle du transistor $T_5$, dont le collecteur est connecté à la base du transistor $T_6$ et dont l'émetteur est connecté au collecteur (point A) du transistor $T_2$, est substitué à la diode $D_3$.

Dans le premier état, le transistor $T_{11}$ est bloqué, et le point A est isolé de la tension d'alimentation Vcc, ce qui évite à la diode $D_2$ et aux transistors $T_8$ et $T_2$ de supporter des tensions en inverse à la limite des tensions d'avalanche des jonctions.

Dans les deux autres états, le transistor $T_{11}$ est conducteur avec une tension collecteur-émetteur très faible (de l'ordre de 200 mV), et sa diode émetteur-base remplit la fonction de la diode $D_3$.

La figure 7 est une variante de la figure 6, mettant en oeuvre des transistors bipolaires $T_5$ et $T_{11}$ non Schottky anti-saturés par une résistance $R_3$ et deux diodes $D_4$ et $D_5$. Cette variante nécessite bien entendu la présence d'une source de courant auxiliaire. La résistance $R_3$ est raccordée entre le point commun aux bases des transistors $T_5$ et $T_{11}$ (point B) et le point commun aux anodes des diodes $D_3$ et $D_4$. Les cathodes des diodes $D_4$ et $D_5$ sont connectés aux collecteurs respectivement des transistors $T_5$ et $T_{11}$. Une source de courant auxiliaire $I_4$ débitant par exemple un courant de 0,5 mA est connectée entre le point B et la source de tension d'alimentation négative -VEE.

Lorsque l'un ou l'autre des transistors $T_5$ et $T_{11}$ conduit, sa tension collecteur-émetteur VCE ($T_5$, $T_{11}$) a pour valeur :

$$V_{CE} (T_5, T_{11}) = V_{BE} (T_5, T_{11}) + R_3 \, I_4 - V_D(D_4, D_5) \approx R_3 \, I_4$$
$$V_{BE}(T_5, T_{11})$$

désignant la tension base-émetteur du transistor $T_5$ ou $T_{11}$ conducteur et $V_D$ ($D_4$,$D_5$) la tension aux bornes de la diode $D_4$ ou $D_5$ qui conduit.

On remarquera en particulier que la tension de sortie à l'état bas, qui est très voisine de $R_3 \, I_4$, peut être ainsi contrôlée et rendue insensible aux variations des paramètres du transistor $T_5$, dûes en particulier aux tolérances du procédé de fabrication.

## Revendications

**1.** Circuit convertisseur de niveaux logiques entre une logique du type mettant en oeuvre des paires de transistors à émetteurs couplés (ECL, CML) et une logique du type transistor-transistor (TTL), et comportant un étage différentiel d'entrée présentant au moins un premier et un deuxième transistors dont les émetteurs sont couplés et une source de courant principale disposée entre lesdits émetteurs couplés et une source de tension d'alimentation négative, dont les collecteurs sont reliés à une source de tension d'alimentation positive chacun à travers repectivement une première et une deuxième résistance, la base du premier transistor étant portée à une tension de référence et celle du deuxième transistor recevant un signal d'entrée dont le niveau est à translater, une première et une deuxième diode ayant leur anode reliée à la masse et leur cathode reliée au collecteur respectivement du premier et du deuxième transistor, et comportant également un étage de sortie présentant un cinquième et un sixième transistor dont les trajets collecteur-émetteur sont en série, le cinquième transistor ayant son émetteur connecté à la masse, sa base connectée au collecteur du premier transistor et son collecteur connecté à l'émetteur du sixième transistor en un point constituant la sortie du circuit convertisseur, et le sixième transistor ayant sa base reliée au collecteur du deuxième transistor et son collecteur connecté à la source de tension d'alimentation positive caractérisé en ce que, pour obtenir en sortie un troisième état, présentant une impédance de sortie élevée, il comporte un septième (T₇) et un huitième (T₈) transistors dont les émetteurs sont couplés et connectés au collecteur d'un neuvième transistor (T₉) dont la base est connectée à celle du deuxième transistor (T₂) et dont l'émetteur est connecté aux émetteurs des premiers (T₁) et deuxième (T₂) transistors, la base du septième transistor (T₇) recevant ladite tension de référence, et le collecteur du septième transistor (T₇) étant connecté à la masse, la base du huitième transistor (T₈) étant connecté à la base d'un dixième transistor (T₁₀) laquelle constitue une entrée de sélection (E₂) dudit troisième état, le collecteur et l'émetteur du dixième transistor (T₁₀) étant connectés respectivement à la masse et à la base du deuxième transistor (T₂), et le collecteur du huitième transistor (T₈) étant connecté à celui du deuxième transistor (T₂), et en ce qu'il comporte une troisième diode (D₃) dont l'anode est connectée à la base du cinquième transistor (T₅) et dont la cathode est connectée au collecteur du deuxième transistor (T₂).

2. Circuit convertisseur selon la revendication 1 caractérisé en ce que l'étage différentiel d'entrée comporte un troisième transistor (T₃) dont le collecteur est à la masse, dont la base reçoit ladite tension de référence et dont l'émetteur est connecté à la base du premier transistor (T₁) ainsi qu'un quatrième transistor (T₄) dont la base reçoit directement ledit signal d'entrée, dont l'émetteur est connecté à la base du deuxième transistor (T₂) et dont le collecteur est à la masse, une première (I₂) et une deuxième (I₃) source de courant auxiliaire étant connectées à l'émetteur respectivement du troisième et du quatrième transistor.

3. Circuit convertisseur selon une des revendications 1 ou 2 caractérisée en ce que ladite troisième diode est la diode base-émetteur d'un onzième transistor (T₁₁) dont la base est connectée à la base du cinquième transistor (T₅) et dont le collecteur est connecté à la base du sixième transistor (T₆) de telle sorte que la base du sixième transistor (T₆) et la deuxième résistance (R₂) sont reliées au collecteur du deuxième transistor (T₂) à travers le trajet collecteur-émetteur du onzième transistor (T₁₁).

4. Circuit convertisseur selon la revendication 1 caractérisé en ce que le cinquième transistor (T₅) est un transistor Schottky.

5. Circuit convertisseur selon la revendication 3 caractérisé en ce que le cinquième transistor (T₅) est un transistor Schottky.

6. Circuit convertisseur selon la revendication 5 caractérisé en ce que le onzième transistor (T₁₁) est un transistor Schottky.

7. Circuit convertisseur selon la revendication 3 caractérisé en ce qu'il comporte un troisième résistance (R₃) disposée en série entre le collecteur du premier transistor (T₁) et la première résistance (R₁) et une quatrième (D₄) et une cinquième (D₅) diode dont les anodes sont connectées entre elles et au point commun à la première (R₁) et à la troisième (R₃) résistance, la cathode de la quatrième diode (D₄) étant connectée à la sortie (S) du circuit convertisseur et celle de la cinquième diode (D₅) au collecteur du onzième transistor (T₁₁), et en ce qu'il comporte une troisième source de courant (I₄) auxiliaire disposée entre le collecteur du premier transistor (T₁) et la source de tension d'alimentation négative, le produit de la valeur de la troisième résistance (R₃) et de l'intensité de la deuxième source de courant (I₄) étant tel que la saturation des cinquième (T₅) et onzième (T₁₁) transistor soit évitée.

## Claims

1. A circuit for converting logic levels between logic of the type utilizing pairs of emitter-coupled transistors (ECL, CML) and logic of the trasistor-trasistor type (TTL), comprising a differential input state which includes at least one first transistor and one second transistor whose emitters are coupled, a principal current source which is connected between said coupled emitters, and a negative supply voltage source, their respective collectors being connected to a positive supply voltage source via a first resistor and a second resistor, respectively, the base of the first transistor being connected to a reference voltage whilst that of the second transistor receives an input signal whose level is to be translated, a first diode and a second diode whose anodes are connected to ground and whose cathodes are connected to the collector of the first transistor and the second transistor, respectively, and also comprising an output stage which includes a fifth transistor and a sixth transistor whose collector-emitter paths are connected in series, the emitter of the fifth transistor being connected to ground, its base being connected to the collector of the first transistor and its collector being connected to the emitter of the sixth transistor at a point which forms the output of the converter circuit, the base of the sixth transistor being connected to the collector of the second transistor whilst its collector is connected to the positive supply voltage source, characterized in that in order to realize a third state on the output, presenting a high output impedance, the converter circuit comprises a seventh transistor ($T_7$) and an eighth ($T_8$) transistor whose emitters are coupled and connected to the collector of a ninth transistor ($T_9$) whose base is connected to that of the second transistor ($T_2$) and whose emitter is connected to the emitters of the first transistor ($T_1$) and the second transistor ($T_2$), the base of the seventh transistor ($T_7$) receiving said reference voltage and the collector of the seventh transistor ($T_7$) being connected to ground, the base of the eighth transistor ($T_8$) being connected to the base of a tenth transistor ($T_{10}$) which constitutes a selection input ($E_2$) for said third state, the collector and the emitter of said tenth transistor ($T_{10}$) being connected to ground and to the base of the second transistor ($T_2$), respectively, the collector of the eighth transistor ($T_8$) being connected to that of the second transistor ($T_2$), and also comprises a third diode ($D_3$) whose anode is connected to the base of the fifth transistor ($T_5$) and whose cathode is connected to the collector of the second transistor ($T_2$).

2. A converter circuit as claimed in Claim 1, characterized in that the differential input stage comprises a third transistor ($T_3$) whose collector is connected to ground, whose base receives said reference voltage and whose emitter is connected to the base of the first transistor ($T_1$), and also comprises a fourth transistor ($T_4$) whose base receives directly said input signal, whose emitter is connected to the base of the second transistor ($T_2$), and whose collector is connected to ground, a first ($I_2$) and a second ($I_3$) auxiliary current source being connected to the emitters of the third transistor and the fourth transistor, respectively.

3. A converter circuit as claimed in Claim 1 or 2, characterized in that said third diode is formed by the base-emitter diode of an eleventh transistor ($T_{11}$) whose base is connected to the base of the fifth transistor ($T_5$) and whose collector is connected to the base of the sixth transistor ($T_6$) so that the base of the sixth transistor ($T_6$) and the second resistor ($R_2$) are connected to the collector of the second transistor ($T_2$) via the collector-emitter path of the eleventh transistor ($T_{11}$).

4. A converter circuit as claimed in Claim 1, characterized in that the fifth transistor ($T_5$) is a Schottky transistor.

5. A converter circuit as claimed in Claim 3, characterized in that the fifth transistor ($T_5$) is a Schottky transistor.

6. A converter circuit as claimed in Claim 5, characterized in that the eleventh transistor ($T_{11}$) is a Schottky transistor.

7. A converter circuit as claimed in Claim 3, characterized in that it comprises a third resistor ($R_3$) which is connected in series between the collector of the first transistor ($T_1$) and the first resistor ($R_1$) and also comprises a fourth diode ($D_4$) and a fifth diode ($D_5$) whose anodes are interconnected at the common junction of the first resistor ($R_1$) and the third resistor ($R_3$), the cathode of the fourth diode ($D_4$) being connected to the output (S) of the converter circuit whilst that of the fifth diode ($D_5$) is connected to the collector of the eleventh transistor ($T_{11}$), the converter circuit also comprising a third auxiliary current source ($I_4$) which is connected between the collector of the first transistor ($T_1$) and the negative supply voltage source, the product of the value of the third resistor ($R_3$) and the intensity of the third current source ($I_4$) being such that saturation of the fifth transistor ($T_5$) and the eleventh transistor ($T_{11}$) is avoided.

## Ansprüche

1. Umsetzerschaltung mit logischen Pegeln zwischen einer Emitteranschlußlogik (ECL, CML) und einer Transistor-Transistor-Logik (TTL) sowie mit einer differentiellen Eingangsstufe, die wenigstens einen ersten und einen zweiten emittergekoppelten Transistor sowie eine zwischen diesen gekoppelten Emittern befindliche Hauptquelle und eine Negativ-Speisespannungsquelle enthält, und die Kollektoren dieses ersten und zweiten Transistors über einen ersten bzw. einen zweiten Widerstand an eine Positiv-Speisespannungsquelle angeschlossen sind, wobei die Basis des ersten Transistors eine Bezugsspannung führt und die Basis des zweiten Transistors ein Eingangssignal empfängt, dessen Pegel verschoben werden muß, eine erste und eine zweite Diode mit ihrer Anode an Masse liegen und mit ihrer Kathode an den Kollektor des ersten bzw. des zweiten Transistors angeschlossen sind, und ebenfalls mit einer Ausgangsstufe, die einen fünften und einen sechsten Transistor enthält, deren Kollektor-Emitter-Strecken in Reihe geschaltet sind, wobei der fünfte Transistor mit seinem Emitter an Masse liegt, mit seiner Basis an den Kollektor des ersten Transistors und mit seinem Kollektor an den Emitter des sechsten Transistors in einem Punkt angeschlossen ist, der den Ausgang der Umsetzerschaltung darstellt, und der sechste Transistor mit seiner Basis an den Kollektor des zweiten Transistors und mit seinem Kollektor an die Positiv-Speisespannungsquelle angeschlossen ist, dadurch gekennzeichnet, daß zum Bewirken eines dritten Zustands, der eine höhere Ausgangsimpedanz darstellt, die Schaltung einen siebten ($T_7$) und einen achten ($T_8$) emittergekoppelten Transistor enthält, deren Emitter an den Kollektor eines neunten Transistors ($T_9$) angeschlossen sind, dessen Basis an die Basis des zweiten Transistors ($T_2$) und dessen Emitter an die Emitter des ersten ($T_1$) und des zweiten Transistors ($T_2$) angeschlossen sind, wobei die Basis des siebten Transistors ($T_7$) die Bezugsspannung empfängt und der Kollektor des siebten Transistors ($T_7$) an Masse liegt, die Basis des achten Transistors ($T_8$) an die Basis eines zehnten Transistors ($T_{10}$) angeschlossen ist, die einen Wähleingang ($E_2$) dieses dritten Zustands darstellt, der Kollektor und der Emitter des zehnten Transistors ($T_{10}$) an Masse liegt bzw. an die Basis des zweiten Transistors ($T_2$) angeschlossen ist, und der Kollektor des achten Transistors ($T_8$) an den Kollektor des zweiten Transistors ($T_2$) angeschlossen ist, und daß die Schaltung eine dritte Diode ($D_3$) enthält, deren Anode an die Basis des fünften Transistors ($T_5$) und deren Kathode an den Kollektor des zweiten Transistors ($T_2$) angeschlossen sind.

2. Umsetzerschaltung nach Anspruch 1, dadurch gekennzeichnet, daß die differentielle Eingangsstufe einen dritten Transistor ($T_3$), dessen Kollektor an Masse liegt, dessen Basis die Bezugsspannung empfängt und dessen Emitter an die Basis des ersten Transistors ($T_1$) angeschlossen ist, sowie einen vierten Transistor ($T_4$) enthält, dessen Basis das Eingangssignal direkt empfängt, dessen Emitter an die Basis des zweiten Transistors ($T_2$) angeschlossen ist und dessen Kollektor an Masse liegt, wobei eine erste ($I_2$) und eine zweite ($I_3$) Hilfsstromquelle an den Emitter des dritten bzw. des vierten Transistors angeschlossen sind.

3. Umsetzerschaltung nach einem der Ansprüche 1 oder 2, dadurch gekennzeichnet, daß die dritte Diode die Basis-Emitter-Diode eines elften Transistors ($T_{11}$) ist, dessen Basis an die Basis des fünften Transistors ($T_5$) und dessen Kollektor an die Basis des sechsten Transistors ($T_6$) derart angeschlossen sind, daß die Basis des sechsten Transistors ($T_6$) und der zweite Widerstand ($R_2$) über die Kollektor-Emitter-Strecke des elften Transistors ($T_{11}$) angeschlossen sind.

4. Umsetzerschaltung nach Anspruch 1, dadurch gekennzeichnet, daß der fünfte Transistor ($T_5$) ein Schottky-Transistor ist.

5. Umsetzerschaltung nach Anspruch 3, dadurch gekennzeichnet, daß der fünfte Transistor ($T_5$) ein Schottky-Transistor ist.

6. Umsetzerschaltung nach Anspruch 5, dadurch gekennzeichnet, daß der elfte Transistor ($T_{11}$) ein Schottky-Transistor ist.

7. Umsetzerschaltung nach Anspruch 3, dadurch gekennzeichnet, daß die Schaltung einen dritten Widerstand ($R_3$) in Reihenschaltung zwischen dem Kollektor des ersten Transistors ($T_1$) und dem ersten Widerstand ($R_1$) und einer vierten ($D_4$) und einer fünften ($D_5$) Diode enthält, deren Anoden miteinander und mit dem gemeinsamen Punkt des ersten ($R_1$) und des dritten ($R_3$) Widerstands verbunden sind, wobei die Kathode der vierten Diode ($D_4$) an den Ausgang ($S$) der Umsetzerschaltung und die Kathode der fünften Diode ($D_5$) an den Kollektor des elften Transistors ($T_{11}$) angeschlossen sind, daß die Schaltung eine zwischen dem Kollektor des ersten Transistors ($T_1$) und der Negativ-Speisespannungsquelle angeschlossene dritte Hilfsstromquelle ($I_4$) enthält, und das Produkt aus dem Widerstand des dritten widerstands ($R_3$) und der Intensität der zweiten Stromquelle ($I_4$) derart ist, daß die Sättigung des fünften ($T_5$) und des elften ($T_{11}$) Transistors vermieden wird.

FIG.1

FIG.2

FIG.3

FIG.4

FIG.5

11

FIG.6

FIG.7